# EUROPEAN PATENT APPLICATION

(11) **EP 3 890 456 A1**
(43) Date of publication of application: **06.10.2021**
(21) Application number: 20167034.6
(22) Date of filing: 31.03.2020
(51) Int. Cl.: H05K 3/00, H05K 3/28, H05K 3/46, H05K 3/24

(54) **COMPONENT CARRIER HOLE CLEANING BY DRY ETCHING WITH PROTECTED INSULATION LAYER**

(71) Applicant: AT & S Austria Technologie & Systemtechnik Aktiengesellschaft, 8700 Leoben-Hinterberg (AT)
(72) Inventor: López Blanco, Vanesa, 15127 A Coruña (ES); Preiner, Erich, 8770 St. Michael (AT); Schrei, Martin, 8382 Mogersdorf (AT)
(74) Representative: Dilg, Haeusler, Schindelmann Patentanwaltsgesellschaft mbH

(57) **Abstract**

It is described a method of manufacturing a component carrier (100). The method comprises (a) providing a core (110) comprising at least one electrically conductive layer structure and/or at least one electrically insulating layer structure; (b) attaching an electrically insulating layer (130) to the core (110); (c) attaching a protection layer (140) to the electrically insulating layer (130); (d) after attaching the protection layer (140), forming a hole (150) extending through the protection layer (140) and the electrically insulating layer (130); and (e) cleaning an interior of the hole (150) by dry etching (190a). It is further described a component carrier resulting from such the described method. The component carrier comprises a hole (150) formed within the electrically insulating layer (130). In a cross-sectional view of the component carrier (110) the hole (150) is laterally delimited by a slanted exterior sidewall portion (250a) and a slanted interior sidewall portion (250b) being angled with respect to the exterior sidewall portion (250a).

## Description

### Field of invention

The present invention relates to the technical field of component carriers, which in electronic applications, may be used as support structures for building up electronic assemblies (i.e. electronic circuits comprising at least one electronic component) or as substrates for carrying integrated (semiconductor) circuit chips.

### Art Background

A component carrier such as a Printed Circuit Board (PCB) is a support structure for at least one electronic component forming an electronic assembly respectively an electronic circuit. Conductor traces representing an interconnecting wiring are formed from a thin metal layer comprising in particular copper. The conductor traces are formed by means of an appropriate structuring or patterning of an electrically conductive layer which is provided on top or beneath an electrically insulating layer of a component carrier. An electronic component may be mounted on an upper or lower surface of a component carrier. In some applications, an electronic component is embedded at least partially within (the volume of) a component carrier.

A so-called multilayer component carrier is a laminated stack consisting of several electrically conductive layer structures and several electrically insulating or dielectric layer structures in an alternating sequence. For electrically connecting different electrically conductive layer structures there are typically used metallized vias extending at least through one electrically insulating layer.

Due to the permanently increasing miniaturization of electronic assemblies, which miniaturization is expected to continue also in the future, there is a need to form (not yet metallized) high precision via structures within at least one layer structure of a multilayer component carrier. A formation of such via structures requires several process steps such as
(i) drilling a hole through the respective (electrically insulating) layer structure e.g. by means of a laser beam;
(ii) forming a protective mask on top of the respective layer structure;
(iii) performing a cleaning step in order to remove smear or debris generated in (the bottom of) the hole during the drilling step, whereby the protective masks protects an (upper) surface of the respective layer structure from getting deteriorated by a cleaning agent;
(iv) removing the protective mask;
(v) electroless plating the (upper) surface and the inner sidewalls of the drilled hole with an electrically conductive material e.g. by means of a sputtering procedure; and
(vi) forming an electrically conductive layer structure on the electroless plated electrically conductive material.

Depending on the specific application additional process steps may have to be carried out in order to manufacture a larger component carrier structure. Such additional process steps may include e.g. a step of patterning the formed electrically conductive layer structure and a built-up procedure for building up an additional (electrically insulating) layer structure. With this additional layer structure the same above identified process steps (i) to (vi) may by carried out in order to further extend the respective component carrier in the (vertical) z-direction being perpendicular to the main surface planes of the layer structures of the component carrier. It is obvious that performing the above identified process steps (i) to (vi) causes a significant effort for manufacturing a (multilayer) component carrier.

There may be a need for improving the efficiency for manufacturing (multilayer) component carriers.

### Summary of the Invention

This need may be met by the subject matter according to the independent claims. Advantageous embodiments of the present invention are described by the dependent claims.

According to a first aspect of the invention there is provided a method of manufacturing a component carrier. The provided method comprises (a) providing a core comprising at least one electrically conductive layer structure and/or at least one electrically insulating layer structure; (b) attaching an electrically insulating layer to the core; (c) attaching a protection layer to the electrically insulating layer; (d) after attaching the protection layer, forming at least one hole extending through the protection layer and the electrically insulating layer; and (e) cleaning an interior of the hole by dry etching.

The described method is based on the idea that by attaching the protection layer to the electrically insulating layer an elaborate process step of providing/creating a dedicated mask for the dry etching process can be omitted. In known methods, such a mask is necessary in order to protect the top surface of the electrically insulating layer from becoming deteriorated, in particular from becoming roughened, when an interior of a before formed hole is cleaned. In such a cleaning step smear of debris is removed, also in known methods, by means of an etching process.

Avoiding a (strong) roughening of the (upper) surface of the electrically insulating layer may provide the advantage that this smooth surface can later be used as a base surface for attaching a seed layer with a small thickness variation. A seed layer with a well-defined thickness may in turn provide the advantage that a further metallization procedure can be carried out in a highly precise manner. This may allow to realize a so-called L/S ratio below 5/5µm or even below 2/2µm. Thereby, L is width of a conductor trace and S is the spacing between neighboring conductor traces.

The smear or debris is typically generated during a drilling procedure with which the described (at least one) hole is formed within the protection layer and the electrically insulating layer. It is mentioned that the described cleaning step is necessary for all kinds of hole formation procedures such as laser drilling and mechanical drilling.

With embodiments of the described invention the process steps for manufacturing a component carrier could be reduced, as the above identified process-step (ii) is replaced by forming a mask in-situ during the hole formation, e.g. by means of laser drilling. In addition to this, this is the most accurate way to produce a mask. This is because a conventionally applied mask has to be produced after a template, but such a template is never as accurate as an in-situ produced mask, due to for instance possible misalignments.

Furthermore, the removal of conventional masks (see above identified process step (iv)) or protection layers is usually much more complicated, as often the removal requires chemicals and an additional cleaning step after the mask has been removed. The additional cleaning step ensures, that no residues remain on the surface. This is not the case with the usage of the protection layer (e.g. a PET foil) described in this document. Specifically, after a later removal or peeling off the protection layer as described below no residues remain on the surface. This makes the described method even more practicable and less expansive. Another advantage of the described method may be that the protection layer acting as a mask is actually "waste". It is removed before a later electroless copper plating step may be applied.

In the context of this document, the term "component carrier" may particularly denote any support structure, which is capable of accommodating one or more components thereon and/or therein for providing mechanical support and/or electrical connectivity. In other words, a component carrier may be configured as a mechanical and/or electronic carrier for (electronic) components. In particular, a component carrier may be one of a printed circuit board (PCB), an organic interposer, and an IC (integrated circuit) substrate. A component carrier may also be a hybrid board combining different ones of the above-mentioned types of component carriers.

The component carrier may be a laminate of the mentioned electrically insulating layer structure(s) and electrically conductive layer structure(s), in particular formed by applying mechanical pressure and/or thermal energy. The mentioned core may provide a plate-shaped component carrier capable of providing a large mounting surface for further components and being nevertheless very thin and compact. The term "layer structure" may particularly denote a continuous layer, a patterned layer or a plurality of non-consecutive islands within a common plane.

According to an embodiment of the invention, before attaching the electrically insulating layer to the core, the protection layer is attached to the electrically insulating layer. This means that after the core is provided the electrically insulating layer and the protection layer are attached to each other (and represent a two-layer stack). The described "pre-attaching" of the protection layer to the electrically insulating layer or vice versa may allow to realize the described method in a particular effective manner.

The two-layer stack may be formed by means of a lamination procedure. Further, the (laminated) two-layer stack may be produced ahead on stock in order to be used as a semifinished product. In the described method this semifinished is then applied or attached to the core (comprising at least one electrically conductive layer structure and/or at least one electrically insulating layer structure). Also the core may be produced ahead on stock as a semifinished product.

According to another embodiment of the invention the dry etching (procedure) comprises plasma etching, in particular Reactive Ion Etching (RIE). Using a plasma etching procedure may result in a particular effective removal of smear being present within the hole. Thereby, a chemically reactive plasma decomposes the smear.

It is mentioned that for most applications the described cleaning (step) comprises solely a dry etching procedure. However, also a combination of dry etching with other known etching procedures might be beneficial for some applications.

According to another embodiment of the invention the method further comprises, after the dry etching, a step of removing the protection layer.

When carrying out the described "maskless" manufacturing method and after removing the protection layer a smooth surface may be given in particular on top of the electrically insulating layer. This may be due to matter of fact that during the dry etching procedure the protection layer protects the upper surface of the electrically insulating layer from becoming roughened by a dry etching substance.

A smooth surface results in a known manner in a small skin effect occurring with an electrically conductive layer formed (later) over the electrically insulating layer, in particular after the protection layer has been removed. Hence, smooth surfaces resulting from the described "maskless" manufacturing method yield a better High Frequency (HF) compatibility of the resulting component carrier.

A further advantage of the described method may be seen in that the electrically conductive layer formed (later) over the electrically insulating layer e.g. by means of a copper deposition could be applied with a significantly increased precision, as the surface roughness is decreased. In addition to this, later formed copper traces show less disturbances within the copper traces. The more precise the copper could be applied the higher is the achievable L/S ratio. Of course, the higher the resolution of the copper traces, the better the HF compatibility and signal transmission. But the actual advantage is the achievable surface roughness, which is significantly decreased, enable a highly accurate copper deposition.

A further advantage of a smooth top surface of the electrically insulating layer may be that an electrically conductive layer formed (later) over the electrically insulating layer can be structured or patterned with a finer resolution. This results in an improvement of the so called fine-line space ratio. For forming the electrically conductive layer a (sputtered) seed layer being attached directly at the electrically insulating layer may be employed.

According to another embodiment of the invention the method further comprises, after removing the protection layer, performing a plasma treatment, in particular a non-reactive plasma activation. The plasma treatment may be realized with an Ar-, N₂-, O₂-, and H₂-plasma or a mixture thereof, e.g. H₂/O₂-plasma. Performing the described plasma treatment may provide the advantage that the roughness of the surface electrically insulating layer can be further reduced.

The advantage of the described plasma treatment may be based on two facts: First, the surface of the electrically insulating layer is additionally cleaned. Thereby, for instance residuals of the removed protection layer can be decomposed. Second, the surface is additionally pre-treated in a way, that a subsequently applied seed-layer could adhere better to the surface for instance because the surface polarity is increased. Usually, the adhesion of metals on such insulating layers is better, the higher the surface roughness of the insulating material is. Unfortunately, the increased surface roughness also decreases the achievable resolution of single copper traces to be formed on the seed layer. This means that the adhesion will be reduced if one increases the resolution by decreasing the surface roughness. Therefore, the described (additional) surface plasma treatment ensures a proper adhesion even on a smooth surface of the electrically insulating layer.

According to another embodiment of the invention, after the formation of the hole, the protection layer has a larger opening than the electrically insulating layer. This may provide the advantage that the step of forming the hole can be carried out without consideration of potentially different material properties of the protection layer and the electrically insulating layer. Hence, for realizing the protection layer a more "weak" material can be used, which later, i.e. after the dry etching, can be removed easily or easier from the electrically insulating layer. This may be realized in a beneficial manner without the additional use of chemicals.

Specifically, in case of a formation of the (at least one) hole by means of laser drilling there is no need to reduce the laser power when the laser beam removes the material of the protection layer as compared to the power being used for effectively removing the material of the electrically insulating layer.

According to another embodiment of the invention forming the hole comprises a laser drilling. Laser drilling may allow to form small vias, e.g. so called micro vias, with a high precision and with a high degree of efficiency. This is of advantage in particular for manufacturing High Density Interconnect (HDI) printed circuit boards.

According to another embodiment of the invention the method further comprises at least one of the following features:
(i) There is additionally carried out a step of surface treating the surface of the electrically insulating layer and the interior of the hole after the dry etching, in particular after removing the protection layer;
(ii) There is additionally carried out a step of at least partially covering walls delimiting said hole with a seed layer, in particular by sputtering or by electroless plating a seed material;
(iii) There is additionally carried out a step of at least partially filling the hole with electrically conductive material, in particular by means of an electroplating procedure.

(i) With the described step of surface treating the roughness of the inner sidewalls of the hole can be adjusted such that further materials, e.g. an adhesion promoting material or a seed material, can be adsorbed at the inner sidewalls of the hole. This may facilitate a further processing of the component carrier by bringing the (at least one) hole in a condition which allows e.g. for an easy and reliable metallization for forming so called inter layer interconnects. The described surface treatment may be realized by on its own with a known surface activation and/or a known surface cleaning procedure. The surface treatment may consist of or may comprise a plasma treatment such as a non-reactive plasma activation procedure as described above.
(ii) Attaching a seed material to the inner surface(s) of the hole may provide the advantage that a further processing of the hole, in a particular filling at least a part of the hole with a conductive material, will result in an (interconnect) structure which comprises a good robustness in particular with respect to mechanic and/or electric properties. Such a robustness may be required in particular for applications wherein the component carrier is subjected to variations in temperature and/or mechanical stress.
(iii) Filling the hole with an electrically conductive material may allow for forming (at least one) via interconnect within the hole. Such an interconnect may be used to connect in a per se known manner a first pattern of conductor traces being formed in a first layer with at least one second pattern of conductor traces being formed in a second layer of a multilayer component carrier. In preferred applications the electrically conductive material is not deposited directly at the inner sidewall(s) of the at least one hole. Instead, first a seed layer as mentioned above is applied to the inner sidewall(s) in particular by means of an electroless procedure and second the electrically conductive material is formed at or over the seed layer.

According to another embodiment of the invention the protection layer comprises or is made from an electrically insulating material.

With a proper insulating material it may be possible to create or maintain a very low roughness of the (upper) surface of the electrically insulating layer which has been attached to the core. This holds true even if an aggressive dry etching is employed for cleaning the interior respectively the bottom of the previously formed hole. Further, during the dry etching process the upper edge of the hole will be protected in a reliable manner such that even an aggressive dry etching procedure will not increase the diameter of the hole (to a significant extent). Hence, the geometry of the hole will remain at least approximately as accurate as it has been formed. Furthermore, an unintentional thickness lost of the electrically insulating layer caused by the dry etching can be prevented at least approximately.

According to another embodiment of the invention the protection layer comprises or is made from at least one of the group consisting of: polyethylene terephthalate (PET), polybutylene terephthalate (PBT), and blends of PET with an added polymer. In a suitable PET blend the amount of PET in wt% may be at least 80% in order to ensure a high hydrophobicity and the dominating properties of PET. The added polymer may be polypropylene, polycarbonates, and/or polystyrene.

Using the above described substances may have the advantage that the protection layer exhibits superior mechanical properties which allow for an effective protection of the upper surface of the electrically insulating layer. A advantage of using these substances and in particular of using PET may be that on the one hand (a) the adhesion onto the insulating material is sufficient enough in order to protect the surface during etching and on the other hand (b) the adhesion onto the insulating material is not so strong that upon removal, a significant amount of residues will remain on the surface or the electrically insulating layer structure.

Further, the described substances and in particular PET comprises a good temperature stability which allows for manufacturing the described component carrier within a wide temperature range.

According to another aspect of the invention there is provided a component carrier (which has been manufactured with a method as described above). The provided method comprises (a) a core comprising at least one electrically conductive layer structure and/or at least one electrically insulating layer structure; and (b) an electrically insulating layer formed on the core. A hole is formed within the electrically insulating layer. Further, in a cross sectional view of the component carrier the hole is laterally delimited by a slanted exterior sidewall portion and a slanted interior sidewall portion being angled with respect to the exterior sidewall portion.

The described component carrier is based on the idea that it can be manufactured without using a dedicated mask for dry etching which mask in known component carrier manufacturing methods is needed during a cleaning procedure for removing smear or debris within the hole by means of dry etching. With such a mask an upper surface of the electrically insulating layer is protected against an unwanted deterioration or roughening.

When manufacturing the described component carrier, in particular with a method as described above, the protection of the upper surface of the electrically insulating layer during a dry etching cleaning procedure is realized with a protection layer which has been formed on or over the electrically insulating layer before the (at least one) hole is formed within the electrically insulating layer and the protection layer. During the etching procedure the protection layer protects all surface portion except the regions of the (at least one) hole. However, the protection layer does not act as a known mask because it is formed uniformly, i.e. without a spatial pattern, on or over the electrically insulating layer before a formation of the hole.

With the described dry etching procedure, a highly accurate smear removal can be realized. This may provide the following advantages:
(A) Less etching compensation is needed which allows for realizing fine L/S ratios. Further, a seed layer thickness-distribution may be improved due to the decreased surface roughness.
(B) The surface protection during the cleaning of the bottom of the via ensures that there is no surface attack which typically results in an unwanted roughness increase.
(C) There will be no "loose glass filler particles" on the surface of the electrically insulating material. In this respect it is mentioned that with some gases, resin of the electrically insulating layer can be attacked but not really the glass fillers within the resin. This may result in so called "loose fillers" that according to the prior art must be removed with a proper wet (etching) method. Otherwise loose fillers would decrease the adhesion of the later sputtered layer on the electrically insulating material. A sputtering on top of loose glass fillers may significantly increase the probability of a later "peeling off" of the sputtered layer.

It is mentioned that in the described component carrier the protection layer has been removed. However, a component carrier which has been manufactured with the method described above is characterized by specific structural features. Specifically, in a cross section the hole does not comprise a simple cylindrical or conical / tapered shape. Instead, in a cross sectional view the hole is laterally delimited by a slanted exterior sidewall portion and a slanted interior sidewall portion. Thereby, the slanting angles are different which results in a more or less sharp kink.

The generation of the differently angled sidewall portions may result from the matter of fact that the etching acts differently in different depths of the hole. Specifically, when forming the hole in particular by means of laser drilling the protection layer may be widened to a larger extend than the electrically insulating layer. This results in that an upper edge of the electrically insulating layer around the hole will be subjected to some dry etching agent also at the upper surface of the electrically insulating layer. As a consequence, the upper portion of the hole will be affected more intensively by the etching agent as compared to the lower or deeper portion of the hole. Descriptively speaking, "deep in the hole" the shape of the hole after etching will correspond more or less to the shape of the hole before etching. In particular, the angle of the sidewall (in a cross-sectional view) will not change. By contrast thereto, more at the opening of the hole the etching agent will change the size and the shape of the hole. Thereby, a widening occurs which results in a different slanting angle of the upper sidewall portion with regard to the lower sidewall portion. Due to the difference in the slanting angle the geometry of the hole after the etching procedure shows that the component carrier has been produced with the above described "maskless" method.

It is mentioned that the described cross-sectional view is taken along a direction which is perpendicular to a normal vector of the main surfaces being defined by the spatial extension of the various layers and/or layer structures of the described component carrier. The three-dimensional shape of the slanted exterior sidewall portion and of the slanted interior sidewall portion may correspond to the surface of a cylinder or of a cone, wherein the symmetry axis of the cylinder or cone is parallel to the normal vector of the above mentioned main surfaces.

According to an embodiment of the invention a bottom surface at the bottom of the hole has a higher surface roughness than an upper surface of the electrically insulating layer, wherein the upper surface of the electrically insulating layer opposes the core.

A low roughness at the upper surface may provide the advantage that conductor traces can be formed thereon which conductor traces are narrow metallic stripes and have a small spacing in between (neighboring conductor traces). Hence, a high integration of electronic circuitry can be realized in structured or patterned layer of electrically conductive material.

According to another embodiment of the invention the cross-sectional shape of the hole comprises at least one of the following features:
(i) the interior sidewall portion is steeper than the exterior sidewall portion;
(ii) the interior sidewall portion is straight;
(iii) the exterior sidewall portion is straight.

These embodiments of the invention show that, at least after the dry etching process, the holes can be realized in various shapes. Hence, there is a comparatively large freedom of design for the entire component carrier. This allows to realize the component carrier in an application specific manner. This means that for a high number of different applications a component carrier with properly designed hole shapes can be used.

According to another embodiment of the invention (i) the electrically insulating layer comprises resin and in particular resin with added reinforcing particles. Alternatively, (ii) the electrically insulating layer is free of reinforcing particles.

The reinforcing particles may be made or may comprise any material, which is capable of reinforcing in particular a cured resin layer. The reinforcing particles may be for instance glass fibers or glass spheres.

According to another embodiment of the invention the electrically insulating layer is (i) a prepreg layer or (ii) a build-up material.

Using a prepreg layer may provide the advantage that the described component carrier may be realized in a simple and effective manner by taking benefit of comparatively cheap and well proven and tested Printed Circuit Board (PCB) materials.

Using a build-up material such as an Ajinomoto Build-up Film (ABF) layer may provide the advantage that the described component carrier may be a high-end component carrier which is characterized by several beneficial properties like a low coefficient of thermal expansion (CTE), a high Young's modulus, a low dielectric loss factor (Df), a low water absorption, and a good reliability in biased Highly Accelerated Stress Testing (HAST).

In the following further considerations are presented which may be relevant at least for some embodiments of the invention:
In some embodiments the component carrier is shaped as a plate. This contributes to the compact design, wherein the component carrier nevertheless provides a large basis for mounting components thereon. The described component carrier may be configured as one of the group consisting of a printed circuit board (PCB), a substrate (in particular an IC substrate), and an interposer.

In the context of this document the term "printed circuit board" (PCB) may particularly denote a plate-shaped component carrier which is formed by laminating several electrically conductive layer structures with several electrically insulating layer structures, for instance by applying pressure and/or by the supply of thermal energy. As preferred materials for PCB technology, the electrically conductive layer structures are made of copper, whereas the electrically insulating layer structures may comprise resin and/or glass fibers, so-called prepreg or FR4 material. The various electrically conductive layer structures may be connected to one another in a desired way by forming through-holes through the laminate, for instance by laser drilling or mechanical drilling, and by filling them with electrically conductive material (in particular copper), thereby forming vias as through-hole connections.

A PCB is usually configured for accommodating one or more components on one or both opposing surfaces of the plate-shaped printed circuit board. They may be connected to the respective main surface by soldering. A dielectric part of a PCB may be composed of resin with reinforcing fibers (such as glass fibers).

Apart from providing attachment surface(s) for surface mounted components a PCB may also be designed with one or more components being embedded at least partially within the PCB. An embedded component may be in particular a naked die. A die, thanks to its typically small thickness, can be conveniently embedded into a PCB being a comparatively thin plate.

In the context of this document, the term "substrate" may particularly denote a small component carrier. A substrate may be a, in relation to a PCB, comparably small component carrier onto which one or more components may be mounted and that may act as a connection medium between one or more chip(s) and a further PCB. For instance, a substrate may have substantially the same size as a component (in particular an electronic component) to be mounted thereon (for instance in case of a Chip Scale Package (CSP)). More specifically, a substrate can be understood as a carrier for electrical connections or electrical networks as well as component carrier comparable to a PCB, however with a considerably higher density of laterally and/or vertically arranged connections. Lateral connections are for example conductive paths, whereas vertical connections may be for example drill holes. These lateral and/or vertical connections are arranged within the substrate and can be used to provide electrical, thermal and/or mechanical connections of housed components or unhoused components (such as bare dies), particularly of IC chips, with a printed circuit board or intermediate printed circuit board. Thus, the term "substrate" also includes "IC substrates". A dielectric part of a substrate may be composed of resin with reinforcing particles (such as reinforcing spheres, in particular glass spheres).

The substrate or interposer may comprise or consist of at least a layer of glass, silicon (Si) or a photo-imageable or dry-etchable organic material like epoxy-based build-up material (such as epoxy-based build-up film) or polymer compounds like polyimide, polybenzoxazole, or benzocyclobutene functionalized epoxy-resin.

In some embodiments, the at least one electrically insulating layer structure comprises at least one of the group consisting of resin (such as reinforced or non-reinforced resins, for instance epoxy resin or bismaleimide-triazine resin), cyanate ester resins, polyphenylene derivate, glass (in particular glass fibers, multi-layer glass, glass-like materials), prepreg material (such as FR-4 or FR-5), polyimide, polyamide, liquid crystal polymer (LCP), epoxy-based build-up film, polytetrafluoroethylene (Teflon, PTFE), a ceramic, and a metal oxide. Reinforcing structures such as webs, fibers or spheres, for example made of glass (multilayer glass) may be used as well. Although prepreg particularly FR4 are usually preferred for rigid PCBs, other materials in particular epoxy-based build-up film or photoimageable dielectric material may be used as well. For high frequency applications, high-frequency materials such as polytetrafluoroethylene, liquid crystal polymer and/or cyanate ester resins, low temperature cofired ceramics (LTCC) or other low, very low or ultra-low DK materials may be implemented in the component carrier as electrically insulating layer structure.

In some embodiments, the at least one electrically conductive layer structure comprises at least one of the group consisting of copper, aluminum, nickel, silver, gold, palladium, and tungsten. Although copper is usually preferred, other materials or coated versions thereof are possible as well, in particular coated with supra-conductive material such as graphene.

A component mounted on or being embedded within the component carrier can be selected from a group consisting of an electrically non-conductive inlay, an electrically conductive inlay (such as a metal inlay, preferably comprising copper or aluminum), a heat transfer unit (for example a heat pipe), a light guiding element (for example an optical waveguide or a light conductor connection), an optical element (for instance a lens), an electronic component, or combinations thereof. For example, the component can be an active electronic component, a passive electronic component, an electronic chip, a storage device (for instance a DRAM or another data memory), a filter, an integrated circuit, a signal processing component, a power management component, an optoelectronic interface element, a light emitting diode, a photocoupler, a voltage converter (for example a DC/DC converter or an AC/DC converter), a cryptographic component, a transmitter and/or receiver, an electromechanical transducer, a sensor, an actuator, a microelectromechanical system (MEMS), a microprocessor, a capacitor, a resistor, an inductance, a battery, a switch, a camera, an antenna, a logic chip, and an energy harvesting unit. However, other components may be embedded in the component carrier. For example, a magnetic element can be used as a component. Such a magnetic element may be a permanent magnetic element (such as a ferromagnetic element, an antiferromagnetic element, a multiferroic element or a ferrimagnetic element, for instance a ferrite core) or may be a paramagnetic element. However, the component may also be a substrate, an interposer or a further component carrier, for example in a board-in-board configuration. The component may be surface mounted on the component carrier and/or may be embedded in an interior thereof. Moreover, also other components, in particular those which generate and emit electromagnetic radiation and/or are sensitive with regard to electromagnetic radiation propagating from an environment, may be used as component.

As has already been mentioned above, the component carrier may be a laminate-type component carrier. In such embodiments, the component carrier is a compound of multiple layer structures which are stacked and connected together by applying a pressing force and/or heat.

After processing interior layer structures of the component carrier, it is possible to cover (in particular by lamination) one or both opposing main surfaces of the processed layer structures symmetrically or asymmetrically with one or more further electrically insulating layer structures and/or electrically conductive layer structures. In other words, a build-up may be continued until a desired number of layers is obtained.

After having completed formation of an extended stack with further electrically insulating layer structures and/or further electrically conductive layer structures, it is possible to proceed with a surface treatment of the obtained layers structures or component carrier. In particular, an electrically insulating solder resist may be applied to one or both opposing main surfaces of the layer stack or component carrier in terms of surface treatment. For instance, it is possible to form such as solder resist on an entire main surface and to subsequently pattern the layer of solder resist so as to expose one or more electrically conductive surface portions which shall be used for electrically coupling the component carrier to an electronic periphery. The surface portions of the component carrier remaining covered with solder resist may be efficiently protected against oxidation or corrosion, in particular surface portions containing copper.

It is also possible to apply a surface finish selectively to exposed electrically conductive surface portions of the component carrier in terms of surface treatment. Such a surface finish may be an electrically conductive cover material on exposed electrically conductive layer structures (such as pads, conductive tracks, etc., in particular comprising or consisting of copper) on a surface of a component carrier. If such exposed electrically conductive layer structures are left unprotected, then the exposed electrically conductive component carrier material (in particular copper) might oxidize, making the component carrier less reliable. A surface finish may then be formed for instance as an interface between a surface mounted component and the component carrier. The surface finish has the function to protect the exposed electrically conductive layer structures (in particular copper circuitry) and enable a joining process with one or more components, for instance by soldering. Examples for appropriate materials for a surface finish are Organic Solderability Preservative (OSP), Electroless Nickel Immersion Gold (ENIG), Electroless Nickel Immersion Palladium Immersion Gold (ENIPIG), gold (in particular Hard Gold), chemical tin, nickel-gold, nickel-palladium, etc.

It has to be noted that embodiments of the invention have been described with reference to different subject matters. In particular, some embodiments have been described with reference to method type claims whereas other embodiments have been described with reference to apparatus type claims. However, a person skilled in the art will gather from the above and the following description that, unless other notified, in addition to any combination of features belonging to one type of subject matter also any combination between features relating to different subject matters, in particular between features of the method type claims and features of the apparatus type claims is considered as to be disclosed with this document.

The aspects defined above and further aspects of the present invention are apparent from the examples of embodiment to be described hereinafter and are explained with reference to the examples of embodiment. The invention will be described in more detail hereinafter with reference to examples of embodiment but to which the invention is not limited.

### Brief Description of the Drawing

- Figures 1a-1g: illustrate the fabrication of a component carrier in accordance with an embodiment of the invention.
- Figures 2a-2c: show enlarged cross sectional views of a hole during the fabrication of the component carrier.

### Detailed Description

It is noted that in different figures, similar or identical elements or features are provided with the same reference signs or with reference signs, which are different from the corresponding reference signs only within the first digit. In order to avoid unnecessary repetitions elements or features, which have already been elucidated with respect to a previously described embodiment, are not elucidated again at a later position of the description.

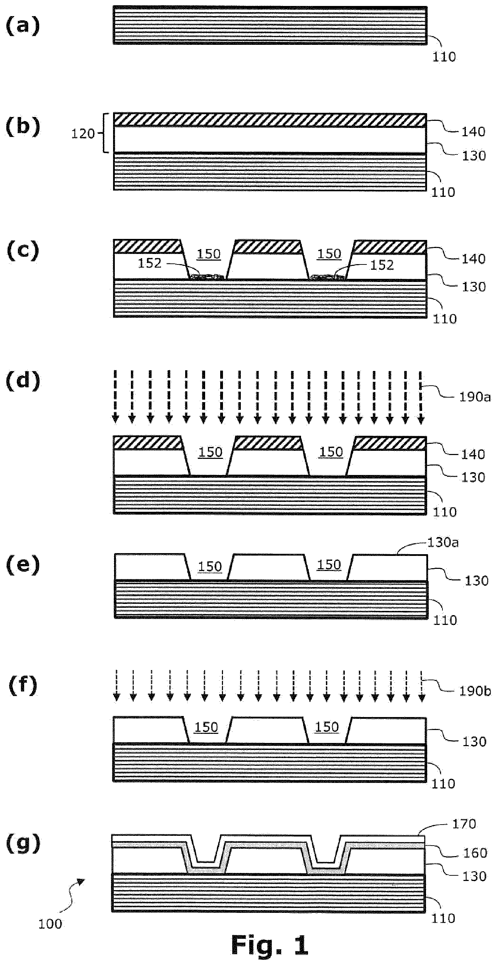

Figures 1a-1g illustrate the fabrication of a component carrier in accordance with an embodiment of the invention.

As can be taken from **Figure 1a****,** the fabrication process starts with providing a core 110. The core 110 may be any more or less solid support structure which is capable of being used as a base structure onto which the process steps described below are carried out. The core 110 comprises at least one electrically conductive layer structure and/or at least one electrically insulating layer structure. The materials being used for the core 110 may be usual Printed Circuit Board (PCB) materials such as copper (for the electrically conductive layer structure(s)) and/or hardened resin such as fully cured FR4 (for the electrically insulating layer structure(s)).

As can be taken from **Figure 1b****,** a two-layer stack 120 is attached to the upper surface of the core 110. According to the exemplary embodiment described here the two-layer stack 120 is a semifinished product which has been produced ahead on stock. The two-layer stack 120 may be a laminate consisting of a build-up material layer 130 representing an electrically insulating layer and a polyethylene terephthalate (PET) layer 140 representing a protection layer. Attaching the two-layer stack 120 to the core 110 may be realized also with a known lamination process.

Next, holes 150 are formed within the two-layer stack 120. According to the exemplary embodiment described here the bottom of the holes 150 coincides with the top surface of the core 110. This means that the holes 150 penetrate the entire two-layer stack 120.

According to the exemplary embodiment described here laser drilling with infrared laser radiation (e.g. with a CO₂ laser) or with UV laser radiation is used for forming the holes 150. During the laser drilling, the PET layer 140 remains on top of the ABF layer 130.

As it is known by the skilled person, laser drilling causes a characteristic geometric shape of the holes 150. This shape is the shape of a truncated cone. In the cross-sectional view shown in **Figure 1c****,** the formed holes 150 have the shape of a trapezoid. As it is further known by the skilled person, every drilling process and in particular a laser drilling process causes a generation of smear or debris 152. After completing the hole formation this smear or debris 152 often remains within the hole 150 and in particular at the bottom surface of the hole 150.

**Figure 1d** shows a next step of the fabrication process wherein the holes 150 are cleaned by removing the smear or debris 152. According to the exemplary embodiment described here this cleaning is carried out with a plasma dry etching procedure, wherein reactive ions impinging from above are used. In Figure 1d this plasma etching is illustrated with the arrows 190a.

During the described dry etching the PET layer 140 acts like a mask, which protects the upper surface of the ABF layer 130 from becoming roughened by the dry etching agents. However, by contrast to known dry etching procedures, this mask is not a separate mask, which has be formed before the dry etching. In accordance with a basic aspect of the invention, the material layer of this mask has been attached to the core 110 together with the ABF layer 140 in the two-layer stack 120. The openings respectively the structures of the mask are produced together with the formation of the holes 150 by means of the above described laser drilling.

After having successfully cleaned the holes 150 the PET layer 140 is removed. This is shown in **Figure 1e****.** Due to the former protection caused by the PET layer 140 an upper surface 130a of the ABF layer 130 has not been roughened and remains smooth.

With the PET layer 140 being removed the panel shown in Figure 1e is ready for an optional further cleaning procedure. This optional further cleaning procedure is illustrated in **Figure 1f****.** According to the exemplary embodiment described here this further cleaning procedure comprises a surface activation/cleaning step by means of a plasma treatment, in particular a non-reactive Argon plasma activation, which is illustrated with the arrows 190b.

It is mentioned that this procedure etching is lees aggressive and causes a significantly less roughening as compared to a roughening which, in the absence of the PET protection layer 140 would be caused by the previous reactive ion plasma etching.

After having cleaned the entire surfaces of the panel by means of the plasma treatment there is carried out a seed layer 160 formation process. According to the exemplary embodiment described here a seed layer material such as Ti is sputtered (a) at the inner walls of the holes and (b) at the surface 130a. The seed layer 160 could be applied either by electroless plating or by sputtering onto the hole panel surface. The seed layer 160 could be for instance neat copper. Further, the seed layer 160 could be a combination of two layers of different metals, such as Ti/Cu, TiW/Cu, CuN/Cu, Al/Cu, etc. Either one metallic layer or two or more metallic layers could be applied in order to form the seed layer 160. According to the exemplary embodiment described here, which is depicted in **Figure 1g****,** the seed layer comprises titanium (sub) seed layer 160 and a copper (sub) seed layer 170. The component carrier is denominated with reference numeral 100.

After formation of the seed layer 160, 170 a (photo) resist layer is applied (not shown in the Figure), in order to electroplate the desired patterning and to fill the vias. Afterwards the resist is removed followed by a different etching step, which removes the seed layer 160, 170 between copper traces (also not shown in the Figure).

It is mentioned that this component carrier 100 may be further extended with additional layers which can be formed with the same process steps as elucidated in this document and/or with other known PCB built up process steps.

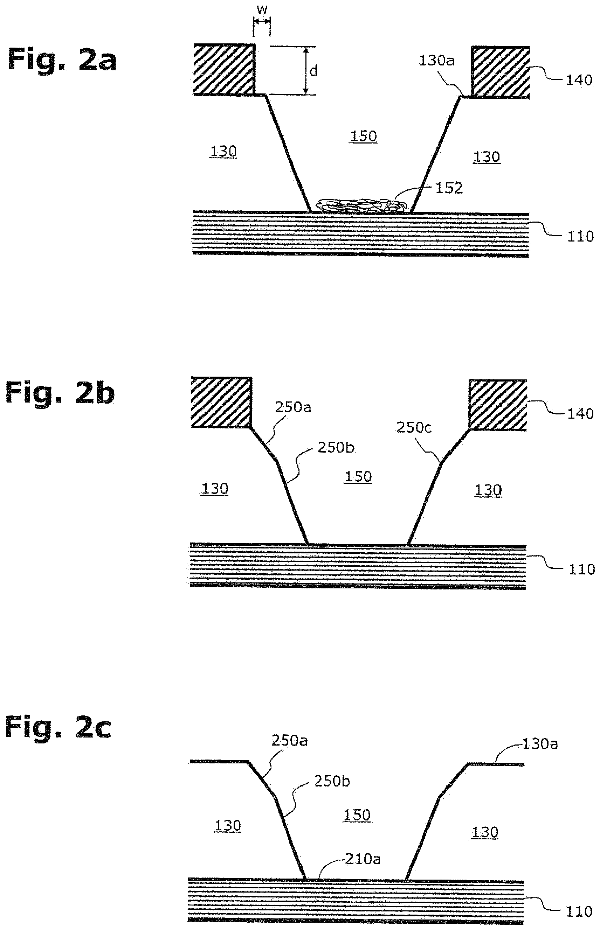

Figures 2a-2c show enlarged cross-sectional views of a hole 150 during the fabrication of the component carrier.

**Figure 2a** shows the hole 150 immediately after the hole laser formation process. At the bottom of the hole 150 there is present smear 152.

The hole 150 has, at least approximately, a truncated cone shape. However, this truncated cone shape does only extend through the ABF layer 130. The PET layer 140, which is more sensitive to the laser radiation as compared to the ABF layer 130, comprises an opening, which compared to the (largest) diameter of the hole 150 at the top of the hole 150 is widened. Descriptively speaking, the laser beam ablates or removes a larger amount of PET material than of ABF material. This results, around the upper edge of the hole 150, in unprotected surface portions at the upper surface 130a of the ABF layer 130.

It is mentioned that the removal of the PET layer 140 typically leads to a fringed surface of the inner sidewall of the hole 150 formed in the PET layer 140. This fringed surface is typically not as straight as depicted in Figure 2a, which is only a schematic representation. However, the stepped shape of the hole 150 (within both the ABF layer 130 and the PET layer 140) shown in Figure 2a is an approximate representation of the actual geometric shape. A typical dimension for the height or the thickness d of the PET layer is 1.4 µm (= 1.4 x 10^6 m). A typical dimension for the radial widening of the PET opening is 1.35 µm (= 1.35 x 10^6 m). Of course, depending on the specific application also other dimensions of the depicted step like shape can be given.

**Figure 2b** shows the hole 150 immediately after the reactive ion dry plasma etching process with which the smear 152 has been removed. It can be seen that in the depicted cross sectional view the hole 150 is laterally delimited by a slanted exterior sidewall portion 250a and a slanted interior sidewall portion 250b. Thereby, the slanting angles are different which results in a more or less sharp kink 250c.

According to the exemplary embodiment described here the generation of the differently angled sidewall portions 250a, 250b is a result of the matter of fact that the etching acts geometrically in a different manner at different surface portions. Specifically, the etching acts differently (a) at the unprotected upper surface 130a and (b) at the (of course also unprotected) inner sidewalls of the holes 150. According to the exemplary embodiment described here the dry reactive ion plasma etching acts on the upper surface 130a in the region around the hole 150 in such a manner that the slanted exterior sidewall portion 250a is formed.

**Figure 2c** shows the geometry of the hole 150 with the PET protection layer 140 being removed.

It should be noted that the term "comprising" does not exclude other elements or steps and the use of articles "a" or "an" does not exclude a plurality. Also elements described in association with different embodiments may be combined. It should also be noted that reference signs in the claims should not be construed as limiting the scope of the claims.

### List of reference signs:

- 100: component carrier
- 110: core
- 120: two-layer stack
- 130: electrically insulating layer / build-up material layer
- 130a: upper surface of layer 130
- 140: protection layer / PET layer
- 150: hole
- 152: smear / debris
- 160: Ti seed layer
- 170: Cu seed layer
- 190a: dry etching / reactive ion plasma etching
- 190b: non-reactive Argon plasma activation

- 210a: bottom of hole
- 250a: slanted exterior sidewall portion
- 250b: slanted interior sidewall portion
- 250c: kink
- d: depth of PET layer
- w: radial widening

## Claims

1. A method of manufacturing a component carrier (100), the method comprising
providing a core (110) comprising at least one electrically conductive layer structure and/or at least one electrically insulating layer structure;
attaching an electrically insulating layer (130) to the core (110); attaching a protection layer (140) to the electrically insulating layer (130); after attaching the protection layer (140), forming a hole (150) extending through the protection layer (140) and the electrically insulating layer (130); and
cleaning an interior of the hole (150) by dry etching (190a).

2. The method as set forth in the preceding claim, wherein,
before attaching the electrically insulating layer (130) to the core (110), the protection layer (140) is attached to the electrically insulating layer (130).

3. The method as set forth in any one of the preceding claims, wherein
the dry etching (190a) comprises plasma etching, in particular Reactive Ion Etching.

4. The method as set forth in any one of the preceding claims, further comprising, after the dry etching (190a),
removing the protection layer (140).

5. The method as set forth in the preceding claim, further comprising, after removing the protection layer (140),
performing a plasma treatment, in particular a non-reactive plasma activation.

6. The method as set forth in any one of the preceding claims, wherein
after the formation of the hole (150) the protection layer (140) has a larger opening than the electrically insulating layer (130).

7. The method as set forth in any one of the preceding claims, wherein
forming the hole (150) comprises a laser drilling.

8. The method as set forth in any one of the preceding claims, further comprising at least one of the following
(i) surface treating the surface of the electrically insulating layer (130) and the interior of the hole (150) after the dry etching (190a), in particular after removing the protection layer (140);
(ii) at least partially covering walls delimiting said hole (150) with a seed layer (160), in particular by sputtering or by electroless plating a seed material;
(iii) at least partially filling the hole (150) with electrically conductive material (170), in particular by means of an electroplating procedure.

9. The method as set forth in any one of the preceding claims, wherein
the protection layer (140) comprises or is made from
an electrically insulating material.

10. The method as set forth in the preceding claim, wherein
the protection layer (140) comprises or is made from at least one of the group consisting of:
polyethylene terephthalate, polybutylene terephthalate, and blends of polyethylene terephthalate with an added polymer.

11. A component carrier (100) comprising
a core (110) comprising at least one electrically conductive layer structure and/or at least one electrically insulating layer structure;
an electrically insulating layer (130) formed on the core (110),
wherein a hole (150) is formed within the electrically insulating layer (130); and wherein in a cross sectional view of the component carrier (110) the hole (150) is laterally delimited by a slanted exterior sidewall portion (250a) and a slanted interior sidewall portion (250b) being angled with respect to the exterior sidewall portion (250a).

12. The component carrier (100) as set forth in the preceding claim, wherein
a bottom surface (210a) at the bottom of the hole (150) has a higher surface roughness than an upper surface (130a) of the electrically insulating layer (130), wherein the upper surface (130a) of the electrically insulating layer (130) opposes the core (110).

13. The component carrier (100) as set forth in any one of the preceding apparatus claims, wherein
the cross-sectional shape of the hole (150) comprises at least one of the following features:
(i) the interior sidewall portion (250b) is steeper than the exterior sidewall portion (250a);
(ii) the interior sidewall portion (250b) is straight;
(iii) the exterior sidewall portion (250a) is straight.

14. The component carrier (100) as set forth in any one of the preceding apparatus claims, wherein
(i) the electrically insulating layer (130) comprises resin and in particular resin with added reinforcing particles or
(ii) the electrically insulating layer (130) is free of reinforcing particles.

15. The component carrier (100) as set forth in any one of the preceding apparatus claims, wherein
the electrically insulating layer (130) is
(i) a prepreg layer or
(ii) a build-up material layer.
